# EUROPEAN PATENT APPLICATION

(11) **EP 4 734 687 A1**
(43) Date of publication of application: **29.04.2026**
(21) Application number: 25209927.0
(22) Date of filing: 20.10.2025
(51) Int. Cl.: H05K 7/20

(54) **SYSTEMS AND METHODS FOR EFFICIENT HEAT REUSE FOR A DATA CENTER**

(30) Priority: 23.10.2024 US 202463710832 P; 09.10.2025 US 202519354796
(71) Applicant: Vertiv International GmbH, 8212 Neuhausen am Rheinfall (CH)
(72) Inventor: MOSCHENI, Andrea, Westerville, 43082 (US)
(74) Representative: Bryn-Jacobsen, Caelia

(57) **Abstract**

A system manager that is configured to monitor and manage an amount of rejected heat within a data center that is provided downstream to a building, house, or machine that is located externally to the data center is disclosed. The system manager receives temperature measurements at various points along a cooling system of the data center and incrementally adjusts temperature set points of chillers, indoor cooling units, and IT equipment. By allowing the chillers, air-cooling units, and IT equipment to operate at slightly less optimal temperature set points, more or less rejected heat may be provided, according to downstream demand.

## Description

### CROSS-REFERENCE TO RELATED APPLICATIONS

This U.S. Non-Provisional Patent Application that claims the benefit of and priority to U.S. Provisional Patent Application No. 63/710,832, filed October 23, 2024.

### TECHNICAL FIELD

This disclosure relates to monitoring and managing amounts of heat reuse for a data center.

### BACKGROUND

Recycling or reusing excess heat that is produced within data centers and then is subsequently provided for use downstream of the data center has, until now, been difficult to scale up, since the fine-tuning the operating temperatures of information technology (IT) equipment and/or other electronic components of the data center requires both precision and constant observation of temperature readings across the entire data center. In particular, high performance computing (HPC) and/or artificial intelligence (AI) workload processing, which is now a typical type of workload that is executed within data centers, often demands even more from liquid cooling systems within data centers, thus adding yet another layer of difficulty to providing a reliable and consistent amount of excess heat for downstream use.

### SUMMARY

An aspect of the disclosed example includes a method for managing heat rejection in a data center. The method includes: receiving a first indication, from a building management system, to increase an amount of rejected heat at an outlet of the data center from a first temperature to a second temperature; receiving at least one temperature measurement corresponding to a temperature of at least one of a chiller, an indoor cooling unit, or a computing device of the data center; determining that the at least one temperature measurement is within an operating temperature range for the at least one of the chiller, the indoor cooling unit, or the computing device of the data center; and in response to the determining that the at least one temperature measurement is within the operating temperature range, executing a thermal reclaiming protocol, wherein the thermal reclaiming protocol comprises: increasing a supply coolant temperature set point between the chiller and the indoor cooling unit; after a first period of time, increasing another supply coolant temperature set point between the indoor cooling unit and the computing device; after a second period of time, determining that another temperature measurement, corresponding to the amount of rejected heat at the outlet of the data center, is at the second temperature; and providing a second indication to the building management system that the amount of rejected heat at the outlet of the data center is measuring at the second temperature.

In another example, a system including a processor and memory containing instructions that, when executed by the processor, cause the processor to perform these steps.

In another example, a non-transitory computer-readable medium includes instructions that, when executed by a processor, cause the processor to perform these steps.

### BRIEF DESCRIPTION OF THE DRAWINGS

The disclosure is best understood from the following detailed description when read in conjunction with the accompanying drawings. It is emphasized that, according to common practice, the various features of the drawings are not to-scale. On the contrary, the dimensions of the various features are arbitrarily expanded or reduced for clarity.
FIG. 1 illustrates a data center environment in which a system manager monitors and adapts working temperature ranges of IT equipment within the data center, according to some examples.
FIG. 2 illustrates another example of a data center environment in which a system manager monitors and adapts working temperature ranges of IT equipment within the data center, according to some examples.
FIG. 3 is a flow diagram that illustrates a computing algorithm that is implemented by the system manager in order to monitor and adapt working temperature ranges of IT equipment within the data center, according to some examples.
FIG. 4 is a flow diagram that illustrates an implementation of the computing algorithm within a data center that is located within a metropolitan area and that provides rejection heat from the data center as reuse heat for the metropolitan area, according to some examples.
FIG. 5 is a visual representation of a trade-off that is optimized by the system manager when monitoring and adapting working temperature ranges of IT equipment within the data center, according to some examples.

### DETAILED DESCRIPTION

Reference will now be made in detail to example examples which are illustrated in the accompanying drawings, wherein like reference numerals refer to like elements throughout. In this regard, the example examples may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

It should be noted that the terms "optimize," "optimal" and the like as used herein can be used to mean making or achieving performance as effective or perfect as possible. However, as one of ordinary skill in the art reading this document will recognize, perfection cannot always be achieved. Accordingly, these terms can also encompass making or achieving performance as good or effective as possible or practical under the given circumstances, or making or achieving performance better than that which can be achieved with other settings or parameters.

Various terms are used to refer to particular system components. Different companies may refer to a component by different names - this document does not intend to distinguish between components that differ in name but not function.

Matters of these example examples that are obvious to those of ordinary skill in the technical field to which these example examples pertain may not be described herein in detail.

It may be understood that the example examples described herein may be considered in a descriptive sense only and not for purposes of limitation. Descriptions of features or aspects within each example example may be considered as available for other similar features or aspects in other example examples.

As the environmental impact of large-scale data centers becomes more and more apparent, techniques for mitigating or otherwise recycling the rejected heat that comes from maintaining the electronics within the data center is of interest to data center owners and providers. By integrating a given data center into the surrounding metropolitan area such that waste heat from the data center may be applied towards heating a house that is located downstream of the data center, for example, the waste heat coming from the data center may be reused, thus limiting the environmental impact of managing such large-scale data centers.

A non-trivial optimization problem exists, however, between properly cooling servers, computing devices, and other IT equipment (e.g., servers within server racks, processors, etc.) such that they can execute HPC workloads while also minimizing the excess heat that is produced by running those servers, computing devices, and other IT equipment. It remains a challenge for data center providers to provide reliable and consistent excess heat emissions, such that the rejected heat may be applied downstream of the data center, while also ensuring that the electronic devices within the data center continue to operate within their respective temperature ranges and do not overheat.

The present disclosure overcomes this challenge by enabling a system manager to both incrementally adjust operating set points of the IT equipment while also ensuring that none of the computing devices overheat past their maximum operating temperature. The system manager may be configured to reference operating temperature ranges of respective coolant distribution units (CDUs), air-cooled chillers, and IT equipment within the data center, and adjust their temperature set points as needed while still monitoring to ensure that they continue to operate within their operating temperature ranges. By incrementally adjusting temperature set points of various devices within the data center, an amount of rejected heat from the data center can be fine-tuned.

As related to the description herein, it should be understood that "waste" heat refers to heat that is emitted from various equipment within a data center, such as an air-cooled chiller, indoor cooling units, IT equipment, CDUs, other electronics, etc. "Waste" heat may also be referred to herein as "rejection" heat, "excess" heat, or any similar term that denotes the concept that it is heat that is being output from the data center and into the environment outside of the data center. Similarly, heat "reuse" refers to the concept that the waste heat from the data center is configured to be applied towards the heating of some downstream building, home, or other piece of equipment or machine. Thus, the waste heat from the data center is recycled, as it is being directed towards some kind of secondary thermal use outside of the data center, rather than being emitted directly into the atmosphere or environment.

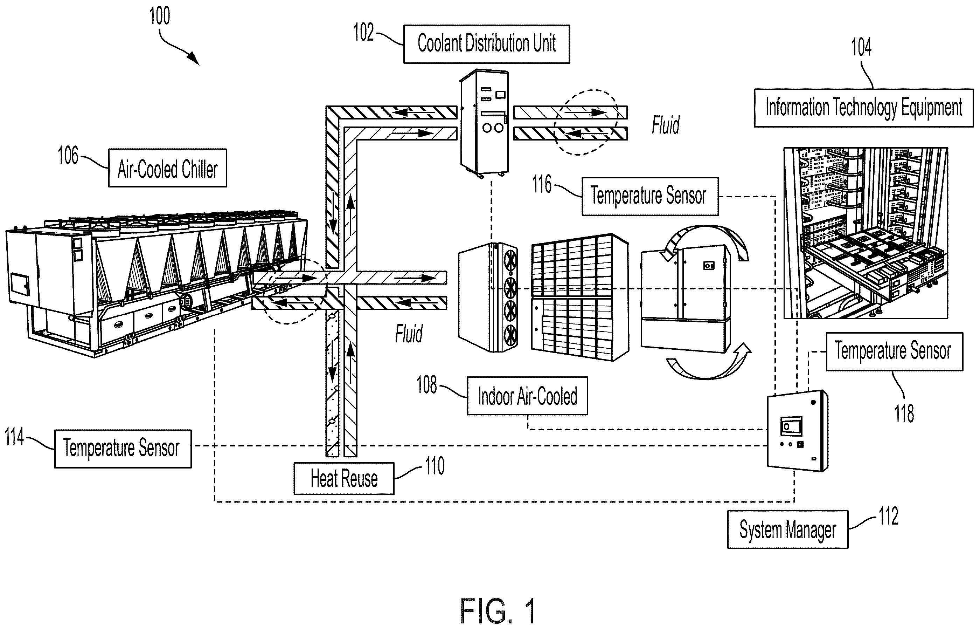

FIG. 1 illustrates a data center environment in which a system manager monitors and adapts working temperature ranges of IT equipment within the data center, according to some examples.

As shown in FIG. 1, a data center environment 100 may include a CDU 102, IT equipment 104, an air-cooled chiller 106, an indoor air-cooling unit 108, and a system manager 112. The data center environment 100 is meant to illustrate various types of electronics and equipment that may require and provide some type of heating and cooling system in order to maintain and contribute to the performance of computing resources within the data center. It should be understood that the data center environment 100 is meant to be illustrative in nature, and that various other configurations of equipment within other data center environments, e.g., more or less pieces of IT equipment, other configurations of IT equipment and their affiliated heating and cooling systems, etc., are also meant to be included in the discussion herein. For example, the data center environment could also include any other type of heat rejection plant besides an indoor chiller, such as a dry cooler or a cooling tower.

Moreover, a cooling system for the data center environment 100 may include air circulation, liquid coolant circulation, or both air and liquid cooling circulation at various physical locations within the data center. For example, FIG. 1 illustrates a liquid coolant circulation between the air-cooled chiller 106 and the air-cooling unit 108, and air circulation between the air-cooling unit 108 and the IT equipment 104. While a hybrid air and liquid cooling system is illustrated in the data center environment 100, other examples of an air cooling system or of a liquid cooling system are similarly meant to be included in the discussion herein.

Furthermore, the IT equipment 104 may resemble a server rack with multiple servers, routers, and switches, or may resemble any other combination of computing devices found within a data center environment.

Also illustrated in FIG. 1 is a heat reuse 110, which is meant to represent an outlet point of the data center shown in FIG. 1 to the larger environment or metropolitan area beyond the physical boundaries of the data center itself. As introduced above, excess heat that is generated within the data center, denoted by the arrow pointing towards the heat reuse 110 outlet point, may be connected to a downstream heating system of a nearby house or building via outlet point 110, thus allowing heat to travel outside of the physical boundaries of the data center and into some other downstream system. Moreover, the heat reuse 110 may represent a point at which the waste heat from the data center is exchanged with a heat recovery system.

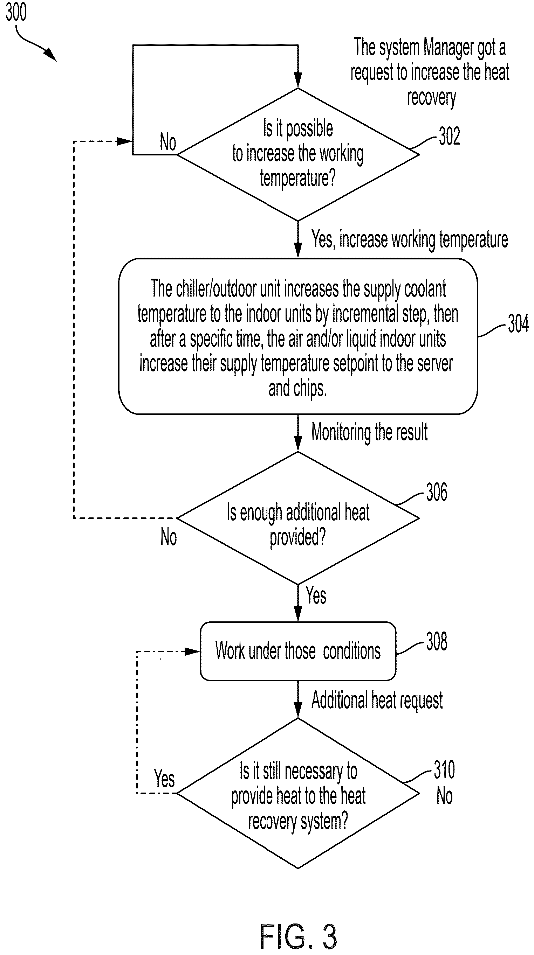

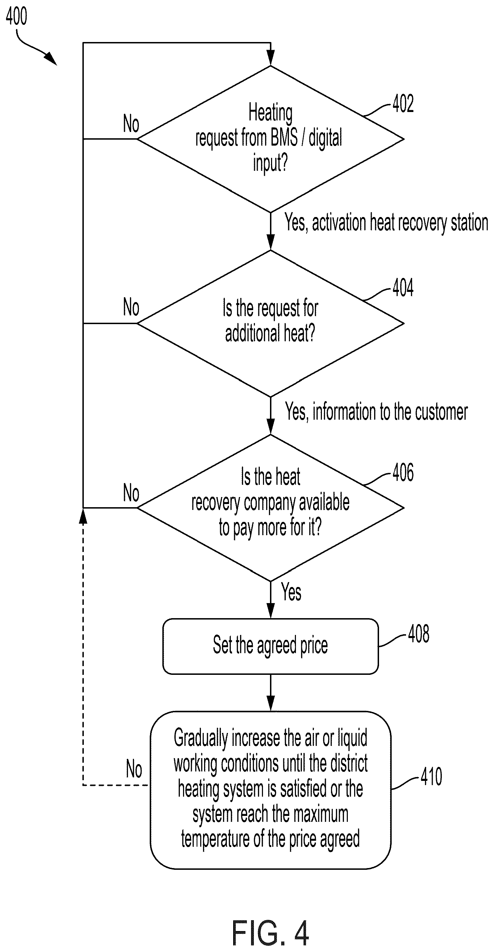

As also introduced above, the demand for more or less heat reuse may fluctuate throughout the seasons of the year, or based on the specific application of the heat reuse into the downstream building or machine, or based on various other factors such as price fluctuations for electric or gas heating in the given metropolitan area that the data center is located in. For example, if the heat reuse 110 is applied as a supplementary means for heating a nearby house, more waste heat from the data center may be requested during the cold winter months, and less heat may be requested during the warm summer months. As such, the system manager 112 may receive an indication, e.g., from the city's utilities company, to increase or decrease the amount of heat that is cycled through the outlet represented by the heat reuse 110 and out into the heating system of the nearby house, and consequently begin adjusting set point temperatures of the various components shown within the data center environment 100 until a point at which the requested increase or decrease in waste heat is met. The process of incrementally adjusting set point temperatures according to an indication to change an amount of excess heat that is made accessible downstream of the data center is additionally discussed herein with regard to the flow diagrams shown in FIGS. 3 and 4.

In some examples, the system manager 112 may be directly or indirectly coupled to the air-cooled chiller 106, the indoor air-cooling unit 108, and the IT equipment 104, as indicated by the dashed lines shown in FIG. 1. The coupling between the system manager 112 and the respective components of the data center environment 110 enables the system manager 112 to receive temperature measurements of the respective components from temperature sensors that are locally connected to those components. For example, a temperature sensor 114 is located proximate to the air-cooled chiller 106, a temperature sensor 116 is located proximate to the indoor air-cooling unit 108, and a temperature sensor 118 is located proximate to the IT equipment 104. This allows a system manager 112 to monitor the current temperatures of the air-cooled chiller 106, the indoor air-cooling unit 108, and the IT equipment 104 with respect to their target temperature set points. This is additionally discussed below with regard to processes 300 and 400, wherein the system manager 112 may be configured to receive overheating device alert messages from any of the air-cooled chiller 106, the indoor air-cooling unit 108, or the IT equipment 104 and take action accordingly.

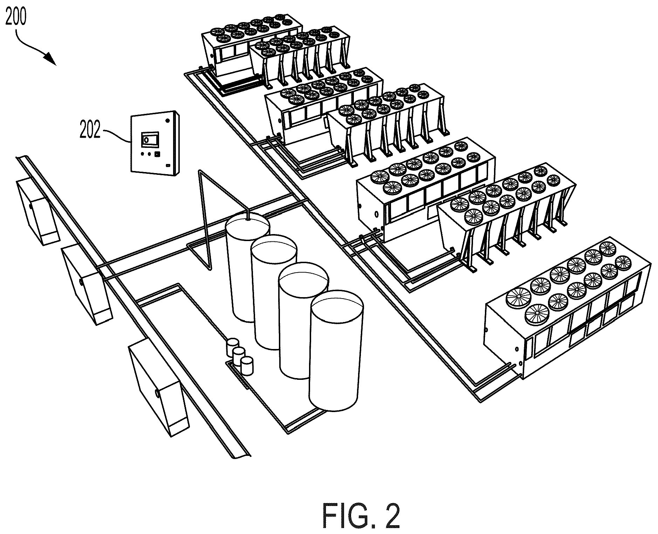

FIG. 2 illustrates another example of a data center environment in which a system manager monitors and adapts working temperature ranges of IT equipment within the data center, according to some examples.

Data center environment 200 shows various types of IT equipment and affiliated heating and cooling systems for that IT equipment, similarly to that which was shown in the data center environment 100. Also illustrated in FIG. 2 is a system manager 202, which monitors the current temperatures of the IT equipment and manages their target temperature set points as the demand for heat reuse increases or decreases.

FIG. 3 is a flow diagram that illustrates a computing algorithm that is implemented by the system manager in order to monitor and adapt working temperature ranges of IT equipment within the data center, according to some examples.

For ease of discussion, a process 300 is discussed below within the context of the system manager 112 applying the computing algorithm within the data center environment 100.

As introduced above, the system manager 112 is configured to monitor the current temperature measurements that correspond to temperatures of the air-cooled chiller 106, the indoor air-cooling unit 108, and the IT equipment 104 within the data center environment 100. At some moment in time prior to initializing the process 300, the monitoring conducted by the system manager 112 may be considered as "passive" in the sense that the system manager 112 may compare periodically updated temperature measurements from temperature sensors that are locally coupled to the various components of the data center, e.g., the temperature sensors 114, 116, and 118, to the temperature set points of those components and verify that the components and devices are operating within the bounds of their normal operating temperature ranges. At a moment in time at the onset of the process 300, the monitoring conducted by the system manager 112 may now be considered as "active" in the sense that the system manager 112 is now going to adjust or modify one or more temperature set points of one or more components within the data center in order to influence the amount of rejected heat that leaves the data center.

In the particular example shown in FIG. 3, the system manager 112 receives a request to increase the amount of rejected heat at the outlet point represented by the heat reuse 110 outlet in FIG. 1. In the following paragraphs, and again for ease of discussion herein, it may be assumed that the request indicates that the temperature of the return from the chilled water system within the data center environment 100 should be adjusted from 34°C to 39°C in order to increase the amount of rejected heat at the outlet point represented by the heat reuse 110.

Subsequently, at the decision-making point illustrated by diamond 302, the system manager 112 determines whether the current temperature measurements of the air-cooled chiller 106, the indoor air-cooling unit 108, and the IT equipment 104 correspond to their respective current temperature set points. If increasing any of the temperature set points will cause any of the equipment or components to potentially overheat, e.g., begin to operate outside of their normal operating temperature ranges, the system manager 112 is configured to provide a response to a computing device of the data center provider indicating that it is not currently possible to increase the operating temperatures of components of the data center environment 110 in order to increase the amount of rejected heat at the heat reuse 110. If, however, the analysis conducted by the system manager 112 concludes that each of the components are still well within their operating temperature ranges, then the system manager 112 confirms that one or more of the temperature set points may be adjusted in order to increase the amount of rejected heat at the heat reuse 110.

For example, if the IT equipment 104 is configured to operate between *X*°C and *Z*°C, and is currently reading a temperature of *Y*°C, wherein *X < Y* < *Z*°C and *Y*°C is less than 90% of *Z*°C, then the system manager 112 may conclude that the IT equipment 104 may indeed be able to operate at a slightly higher, and slightly less optimal, temperature and still remain within its range of normal operation of between *X*°C and *Z*°C.

If the temperature set points of equipment within the data center environment 100 may indeed be increased, then the system manager 112 activates a thermal reclaiming protocol. Steps of this protocol are additionally described below with regard to block 304, diamond 306, block 308, and diamond 310. In some examples, a first step within the thermal reclaiming protocol is for the system manager 112 to provide a message via the Building Management System (BMS) for the data center to respective processors, hereinafter "control units," that control operating parameters of the air-cooled chiller 106, the indoor air-cooling unit 108, and the IT equipment 104. The message indicates that the thermal reclaiming protocol is activated until further notice, and that temperature set points of the respective components that the control units are controlling may change, in which case no alarm from the control units are to be signaled unless the component is close (e.g., 90% of *Z*°C in the example above) to reaching the maximum acceptable operating temperature of the given operating temperature range (e.g., between *X*°C and *Z*°C in the example above). In some examples, "close" to reaching a threshold limit of operation may also be defined as a ≤90% opening of the modulating valve/pump limit at various components within the data center.

In block 304, the system manager 112 may then begin a process of incrementally increasing the temperature set points of one or more components within the data center environment 100 in order to reach the amount of requested rejection heat at the heat reuse 110. In some examples, the system manager 112 is configured to carry out this protocol step-by-step, and with time allotted in between each step. This ensures that no temperature of any component overshoots its operating temperature range and risks damaging the equipment. For example, the system manager 112 may firstly increase a supply coolant temperature from the air-cooled chiller 106 to the indoor air-cooled unit 108. The incremental increase of the supply coolant temperature may resemble one degree, one-half degree, or any other small incremental increase to the set point temperature, such that an incremental as opposed to a drastic change should be affected to components that are downstream of the air-cooled chiller 106.

In some examples, and in order to adjust the supply coolant temperature from the air-cooled chiller 106 to the indoor air-cooled unit 108, the system manager 112 may be configured to send a message to the control units of the air-cooled chiller 106 and the indoor air-cooled unit 108 that indicates the modification to the original temperature set point for supply coolant temperature.

The system manager 112 then continues to monitor incoming temperature measurements of respective components within the data center environment 100 for a given amount of time. If the system manager 112 continues to receive temperature measurements that are within respective operating temperature ranges of the components within the data center environment 100, then, after that given amount of time, the system manager 112 proceeds with adjusting the supply temperature set point of the supply coolant between the indoor air-cooled unit 108 and the IT equipment 104. Similarly to that which is described above, the incremental increase of the supply coolant temperature set point may resemble one degree, one-half degree, or any other small incremental increase to the set point temperature, such that an incremental as opposed to a drastic change should be affected to the IT equipment 104.

In some examples, and in order to adjust the supply coolant between the indoor air-cooled unit 108 and the IT equipment 104, the system manager 112 may be configured to send a message to the control units of the indoor air-cooled unit 108 and the IT equipment 104 that indicates the modification to the original temperature set point for supply coolant temperature.

The system manager 112 then continues to monitor incoming temperature measurements of respective components within the data center environment 100 for another amount of time. If the system manager 112 continues to receive temperature measurements that are within respective operating temperature ranges of the components within the data center environment 100, then, after that second period of amount of time passes, the system manager 112 proceeds towards decision-making point in diamond 306.

At the decision-making point in diamond 306, the system manager 112 again receives incoming temperature measurements from temperature sensors that are locally connected to the various components within the data center environment 100. A first checkpoint of this analysis is to verify that the respective components are still operating within their normal operating temperature ranges, e.g., between *X*°C and *Z*°C for the IT equipment 104 in the example given above, and that no components are now at risk of overheating due to the change in set point temperatures that occurred in block 304.

A second checkpoint of this analysis is then to determine the temperature measurement at the outlet point represented by the heat reuse 110 relative to requested change in rejected heat. If the incremental adjustments to (1) the supply coolant temperature from the air-cooled chiller 106 to the indoor air-cooled unit 108 and (2) the supply coolant temperature between the indoor air-cooled unit 108 and the IT equipment 104 have indeed resulted in the temperature at the return from the chilled water system within the data center environment 100 moving from 34°C to 39°C, then the request received at the beginning of the process 300 has been met, and the increased amount of rejected heat at the outlet point represented by the heat reuse 110 reflects the requested change. As shown in block 308, the system manager 112 will now continue to monitor temperature measurements of the various components of the data center environment 100 to ensure that the newly adjusted temperature set points are applied.

If, however, the incremental adjustments to (1) the supply coolant temperature from the air-cooled chiller 106 to the indoor air-cooled unit 108 and (2) the supply coolant temperature between the indoor air-cooled unit 108 and the IT equipment 104 have not yet resulted in the temperature at the return from the chilled water system within the data center environment 100 moving from 34°C to 39°C, then the process illustrated by diamond 302 and block 304 is repeated one or more times until the request for increased rejection heat is met or until the system manager 112 can no longer increase temperature set points, e.g., because a given component of the data center is nearing the maximum of its operating temperature range.

Diamond 310 further illustrates some moment in time in the future, after a period of time has passed in which system manager has continued to monitor temperature measurements and compare them to the elevated temperature set points. The system manager 112 may periodically reconfirm that the temperature at the return from the chilled water system within the data center environment 100 should be set to 39°C. If yes, then the system manager 112 continues to work under those conditions, as indicated by block 308. If, however, the system manager 112 receives a new request to decrease the temperature at the return from the chilled water system within the data center environment 100 back to 34°C, for example, then the system manager 112 may begin to incrementally decrease the various temperature set points back down. For example, the system manager 112 may (1) decrease the supply coolant temperature between the indoor air-cooled unit 108 and the IT equipment 104, wait for a period of time, then (2) decrease the supply coolant temperature from the air-cooled chiller 106 to the indoor air-cooled unit 108. This process may be repeated one or more times until the temperature at the return from the chilled water system within the data center environment 100 reaches 34°C.

After a moment in time at which the temperature at the return from the chilled water system within the data center environment 100 reaches 34°C, the system manager 112 may then send another message via the BMS for the data center to the respective control units, indicating that the thermal reclaiming protocol is no longer active until further notice.

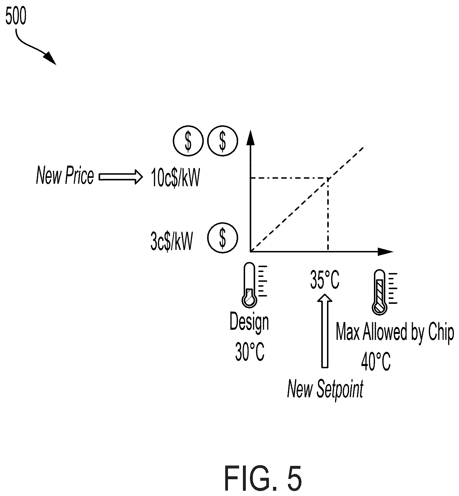

FIG. 4 is a flow diagram that illustrates an implementation of the computing algorithm within a data center that is located within a metropolitan area and that provides rejection heat from the data center as reuse heat for the metropolitan area, according to some examples. In addition, FIG. 5 is a visual representation 500 of a trade-off that is optimized by the system manager when monitoring and adapting working temperature ranges of IT equipment within the data center, according to some examples.

The following paragraphs reference the illustrations provided in both FIGS. 4 and 5.

In some examples, a process 400 may occur prior to the onset of the process 300. For example, a city utilities company may approach the data center provider to request that an increased amount of waste heat be provided to buildings, houses, machines, etc. that are located downstream from the data center. As illustrated by diamonds 402 and 404, if it is confirmed that the request is indeed for an increased/decreased amount of waste heat from the data center as opposed to some other type of request, then information may be provided to the data center provider, as shown in FIG. 5.

In FIG. 5, the x-axis of the visual representation 500 depicts a range of operating temperatures that the IT equipment 104 may operate at that are slightly less optimal than the "design" operating temperature of 30°C but that are still below the maximum operating temperature of the IT equipment 104, namely "max allowed by chip 40°C. The *y*-axis of the visual representation 500 depicts a range of prices that the city utilities company charges the data center for electricity usage. The relationship shown in the plot thus illustrates how a new temperature set point (e.g., 35°C) of the IT equipment 104 may be utilized in order to provide additional waste heat out of the data center for use in heating buildings/houses/machines located downstream from the data center.

Returning now to diamond 406 in the process 400 in FIG. 4, if the data center provider agrees to pay more for electricity charges in order to adjust the temperature set point of IT equipment 104 and provide more waste heat, then the agreed upon price is fixed, as shown in block 408.

Block 410 thus marks a moment in time at which the system manager 112 receives the request that indicates that the temperature of the return from the chilled water system within the data center environment 100 should be adjusted from 34°C to 39°C in order to increase the amount of rejected heat at the outlet point represented by the heat reuse 110. The process 300 illustrated in FIG. 3 then begins.

Further examples are set out in the clauses below:
1. A method for managing heat rejection in a data center, the method comprising:
   receiving a first indication, from a building management system, to increase an amount of rejected heat at an outlet of the data center from a first temperature to a second temperature;
   receiving at least one temperature measurement corresponding to a temperature of at least one of a chiller, an air-cooling unit, or a computing device of the data center;
   determining that the at least one temperature measurement is within an operating temperature range for the at least one of the chiller, the air indoor cooling unit, or the computing device of the data center; and
   in response to the determining that the at least one temperature measurement is within the operating temperature range, executing a thermal reclaiming protocol, wherein the thermal reclaiming protocol comprises:
      increasing a supply coolant temperature set point between the chiller and the air-cooling unit;
      after a first period of time, increasing another supply coolant temperature set point between the air indoor cooling unit and the computing device;
      after a second period of time, determining that another temperature measurement, corresponding to the amount of rejected heat at the outlet of the data center, is at the second temperature; and
      providing a second indication to the building management system that the amount of rejected heat at the outlet of the data center is measuring at the second temperature.
2. The method of clause 1, wherein, prior to the executing the thermal reclaiming protocol, the method further comprises:
   monitoring valve opening positions within a liquid cooling system of the data center; and
   responsive to determining that one or more of the valve opening positions are not currently positioned at a maximum limit, proceeding to the executing the thermal reclaiming protocol.
3. The method of clause 1 or 2, wherein the executing the thermal reclaiming protocol further comprises providing respective messages to control units of the chiller, the air indoor cooling unit, and the computing device, wherein the messages indicate that the thermal reclaiming protocol is active.
4. The method of any one of the preceding clauses, wherein the executing the thermal reclaiming protocol further comprises providing respective messages to control units of the chiller and the air indoor cooling unit, wherein the messages indicate that the supply coolant temperature set point has been increased.
5. The method of any one of the preceding clauses, wherein the executing the thermal reclaiming protocol further comprises providing respective messages to control units of the air indoor cooling unit and the computing device, wherein the messages indicate that the other supply coolant temperature set point has been increased.
6. The method of any one of the preceding clauses, further comprising:
   receiving a third indication, from the building management system, to decrease the amount of rejected heat at the outlet of the data center from the second temperature to a third temperature, wherein the third temperature is less than the second temperature;
   decreasing the coolant temperature set point between the air indoor cooling unit and the computing device;
   after a third period of time, decreasing the supply coolant temperature set point between the chiller and the air indoor cooling unit;
   after a fourth period of time, determining that another temperature measurement, corresponding to the amount of rejected heat at the outlet of the data center, is at the third temperature; and
   providing a fourth indication to the building management system that the amount of rejected heat at the outlet of the data center is measuring at the third temperature.
7. A system for managing heat rejection in a data center, the system comprising:
   a processor; and
   memory having program instructions that, when executed by the processor, cause the processor to:
      receive a first indication, from a building management system, to increase an amount of rejected heat at an outlet of the data center from a first temperature to a second temperature;
      receive at least one temperature measurement corresponding to a temperature of at least one of a chiller, an air indoor cooling unit, or a computing device of the data center;
      determine that the at least one temperature measurement is within an operating temperature range for the at least one of the chiller, the air indoor cooling unit, or the at least one computing device of the data center; and
      in response to the determination that the at least one temperature measurement is within the operating temperature range, execute a thermal reclaiming protocol, wherein, to execute the thermal reclaiming protocol, the program instructions further cause the processor to:
         increase a supply coolant temperature set point between the chiller and the air-cooling unit;
         after a first period of time, increase another supply coolant temperature set point between the air indoor cooling unit and the at least one computing device;
         after a second period of time, determine that another temperature measurement, corresponding to the amount of rejected heat at the outlet of the data center, is at the second temperature; and
         provide a second indication to the building management system that the amount of rejected heat at the outlet of the data center is reading at the second temperature.
8. The system of clause 7, further comprising a temperature sensor located proximate to the chiller and configured to provide temperature measurements to the processor.
9. The system of clause 7, further comprising a temperature sensor located proximate to the air-cooling unit and configured to provide temperature measurements to the processor.
10. The system of clause 7, further comprising a temperature sensor located proximate to the computing device and configured to provide temperature measurements to the processor.
11. The system of any one of clauses 7-10, wherein, prior to the execution of the thermal reclaiming protocol, the program instructions further cause the processor to:
   monitor valve opening positions within a liquid cooling system of the data center; and
   responsive to the determination that one or more of the valve opening positions are not currently positioned at a maximum limit, proceed to the execution of the thermal reclaiming protocol.
12. The system of any one of clauses 7-11, wherein, to execute the thermal reclaiming protocol, the program instructions further cause the processor to provide respective messages to control units of the chiller, the air-cooling unit, and the computing device, wherein the messages indicate that the thermal reclaiming protocol is active.
13. The system of any one of clauses 7-12, wherein, to execute the thermal reclaiming protocol, the program instructions further cause the processor to provide respective messages to control units of the chiller and the air indoor cooling unit, wherein the messages indicate that the supply coolant temperature set point has been increased.
14. The system of any one of clauses 7-13, wherein, to execute the thermal reclaiming protocol, the program instructions further cause the processor to provide respective messages to control units of the air indoor cooling unit and the computing device, wherein the messages indicate that the other supply coolant temperature set point has been increased.
15. The system of any one of clauses 7-14, wherein the program instructions further cause the processor to:
   receive a third indication, from the building management system, to decrease the amount of rejected heat at the outlet of the data center from the second temperature to a third temperature, wherein the third temperature is less than the second temperature;
   decrease the coolant temperature set point between the air-cooling unit and the computing device;
   after a third period of time, decrease the supply coolant temperature set point between the chiller and the air-cooling unit;
   after a fourth period of time, determine that another temperature measurement, corresponding to the amount of rejected heat at the outlet of the data center, is at the third temperature; and
   provide a fourth indication to the building management system that the amount of rejected heat at the outlet of the data center is measuring at the third temperature.
16. A non-transitory, computer-readable medium storing program instructions that, when executed on or across a processor, cause the processor to:
   receive a first indication, from a building management system of a data center, to increase an amount of rejected heat at an outlet of the data center from a first temperature to a second temperature;
   receive at least one temperature measurement corresponding to a temperature of at least one of a chiller, an air indoor cooling unit, or a computing device of the data center;
   determine that the at least one temperature measurement is within an operating temperature range for the at least one of the chiller, the air indoor cooling unit, or the at least one computing device of the data center; and
   in response to the determination that the at least one temperature measurement is within the operating temperature range, execute a thermal reclaiming protocol, wherein, to execute the thermal reclaiming protocol, the program instructions further cause the processor to:
      increase a supply coolant temperature set point between the chiller and the air-cooling unit;
      after a first period of time, increase another supply coolant temperature set point between the air-cooling unit and the at least one computing device;
      after a second period of time, determine that another temperature measurement, corresponding to the amount of rejected heat at the outlet of the data center, is at the second temperature; and
      provide a second indication to the building management system that the amount of rejected heat at the outlet of the data center is reading at the second temperature.
17. The non-transitory, computer-readable medium of clause 16, wherein, prior to the execution of the thermal reclaiming protocol, the program instructions further cause the processor to:
   monitor valve opening positions within a liquid cooling system of the data center; and
   responsive to the determination that one or more of the valve opening positions are not currently positioned at a maximum limit, proceed to the execution of the thermal reclaiming protocol.
18. The non-transitory, computer-readable medium of clause 16 or 17, wherein, to execute the thermal reclaiming protocol, the program instructions further cause the processor to provide respective messages to control units of the chiller, the air indoor cooling unit, and the computing device, wherein the messages indicate that the thermal reclaiming protocol is active.
19. The non-transitory, computer-readable medium of any one of clauses 16-18, wherein, to execute the thermal reclaiming protocol, the program instructions further cause the processor to provide respective messages to control units of the chiller and the air indoor cooling unit, wherein the messages indicate that the supply coolant temperature set point has been increased.
20. The non-transitory, computer-readable medium of any one of clauses 16-19, wherein, to execute the thermal reclaiming protocol, the program instructions further cause the processor to provide respective messages to control units of the air indoor cooling unit and the computing device, wherein the messages indicate that the other supply coolant temperature set point has been increased.

While example examples have been described with reference to the figures, it will be understood by those of ordinary skill in the art that various changes in form and details may be made therein without departing from the scope as defined by the following claims.

## Claims

1. A method for managing heat rejection in a data center, the method comprising:
receiving a first indication, from a building management system, to increase an amount of rejected heat at an outlet of the data center from a first temperature to a second temperature;
receiving at least one temperature measurement corresponding to a temperature of at least one of a chiller, an air-cooling unit, or a computing device of the data center;
determining that the at least one temperature measurement is within an operating temperature range for the at least one of the chiller, the indoor cooling unit, or the computing device of the data center; and
in response to the determining that the at least one temperature measurement is within the operating temperature range, executing a thermal reclaiming protocol, wherein the thermal reclaiming protocol comprises:
increasing a supply coolant temperature set point between the chiller and the air-cooling unit;
after a first period of time, increasing another supply coolant temperature set point between the indoor cooling unit and the computing device;
after a second period of time, determining that another temperature measurement, corresponding to the amount of rejected heat at the outlet of the data center, is at the second temperature; and
providing a second indication to the building management system that the amount of rejected heat at the outlet of the data center is measuring at the second temperature.

2. The method of claim 1, wherein, prior to the executing the thermal reclaiming protocol, the method further comprises:
monitoring valve opening positions within a cooling system of the data center; and
responsive to determining that one or more of the valve opening positions are not currently positioned at a maximum limit, proceeding to the executing the thermal reclaiming protocol.

3. The method of claim 1 or 2, wherein the executing the thermal reclaiming protocol further comprises providing respective messages to control units of the chiller, the indoor cooling unit, and the computing device, wherein the messages indicate that the thermal reclaiming protocol is active.

4. The method of any one of the preceding claims, wherein the executing the thermal reclaiming protocol further comprises providing respective messages to control units of the chiller and the indoor cooling unit, wherein the messages indicate that the supply coolant temperature set point has been increased.

5. The method of any one of the preceding claims, wherein the executing the thermal reclaiming protocol further comprises providing respective messages to control units of the indoor cooling unit and the computing device, wherein the messages indicate that the other supply coolant temperature set point has been increased.

6. The method of any one of the preceding claims, further comprising:
receiving a third indication, from the building management system, to decrease the amount of rejected heat at the outlet of the data center from the second temperature to a third temperature, wherein the third temperature is less than the second temperature;
decreasing the coolant temperature set point between the indoor cooling unit and the computing device;
after a third period of time, decreasing the supply coolant temperature set point between the chiller and the indoor cooling unit;
after a fourth period of time, determining that another temperature measurement, corresponding to the amount of rejected heat at the outlet of the data center, is at the third temperature; and
providing a fourth indication to the building management system that the amount of rejected heat at the outlet of the data center is measuring at the third temperature.

7. A system for managing heat rejection in a data center, the system comprising:
a processor; and
memory having program instructions that, when executed by the processor, cause the processor to:
receive a first indication, from a building management system, to increase an amount of rejected heat at an outlet of the data center from a first temperature to a second temperature;
receive at least one temperature measurement corresponding to a temperature of at least one of a chiller, an indoor cooling unit, or a computing device of the data center;
determine that the at least one temperature measurement is within an operating temperature range for the at least one of the chiller, the indoor cooling unit, or the at least one computing device of the data center; and
in response to the determination that the at least one temperature measurement is within the operating temperature range, execute a thermal reclaiming protocol, wherein, to execute the thermal reclaiming protocol, the program instructions further cause the processor to:
increase a supply coolant temperature set point between the chiller and the air-cooling unit;
after a first period of time, increase another supply coolant temperature set point between the indoor cooling unit and the at least one computing device;
after a second period of time, determine that another temperature measurement, corresponding to the amount of rejected heat at the outlet of the data center, is at the second temperature; and
provide a second indication to the building management system that the amount of rejected heat at the outlet of the data center is reading at the second temperature.

8. The system of claim 7, further comprising a temperature sensor located proximate to the chiller and configured to provide temperature measurements to the processor.

9. The system of claim 7, further comprising a temperature sensor located proximate to the air-cooling unit and configured to provide temperature measurements to the processor.

10. The system of claim 7, further comprising a temperature sensor located proximate to the computing device and configured to provide temperature measurements to the processor.

11. The system of any one of claims 7-10, wherein, prior to the execution of the thermal reclaiming protocol, the program instructions further cause the processor to:
monitor valve opening positions within a cooling system of the data center; and
responsive to the determination that one or more of the valve opening positions are not currently positioned at a maximum limit, proceed to the execution of the thermal reclaiming protocol.

12. The system of any one of claims 7-11, wherein, to execute the thermal reclaiming protocol, the program instructions further cause the processor to provide respective messages to control units of the chiller, the air-cooling unit, and the computing device, wherein the messages indicate that the thermal reclaiming protocol is active.

13. The system of any one of claims 7-12, wherein, to execute the thermal reclaiming protocol, the program instructions further cause the processor to provide respective messages to control units of the chiller and the indoor cooling unit, wherein the messages indicate that the supply coolant temperature set point has been increased; or optionally
wherein, to execute the thermal reclaiming protocol, the program instructions further cause the processor to provide respective messages to control units of the indoor cooling unit and the computing device, wherein the messages indicate that the other supply coolant temperature set point has been increased; or optionally
wherein the program instructions further cause the processor to:
receive a third indication, from the building management system, to decrease the amount of rejected heat at the outlet of the data center from the second temperature to a third temperature, wherein the third temperature is less than the second temperature;
decrease the coolant temperature set point between the air-cooling unit and the computing device;
after a third period of time, decrease the supply coolant temperature set point between the chiller and the air-cooling unit;
after a fourth period of time, determine that another temperature measurement, corresponding to the amount of rejected heat at the outlet of the data center, is at the third temperature; and
provide a fourth indication to the building management system that the amount of rejected heat at the outlet of the data center is measuring at the third temperature.

14. A computer-readable medium storing program instructions that, when executed on or across a processor, cause the processor to:
receive a first indication, from a building management system of a data center, to increase an amount of rejected heat at an outlet of the data center from a first temperature to a second temperature;
receive at least one temperature measurement corresponding to a temperature of at least one of a chiller, an indoor cooling unit, or a computing device of the data center;
determine that the at least one temperature measurement is within an operating temperature range for the at least one of the chiller, the indoor cooling unit, or the at least one computing device of the data center; and
in response to the determination that the at least one temperature measurement is within the operating temperature range, execute a thermal reclaiming protocol, wherein, to execute the thermal reclaiming protocol, the program instructions further cause the processor to:
increase a supply coolant temperature set point between the chiller and the air-cooling unit;
after a first period of time, increase another supply coolant temperature set point between the air-cooling unit and the at least one computing device;
after a second period of time, determine that another temperature measurement, corresponding to the amount of rejected heat at the outlet of the data center, is at the second temperature; and
provide a second indication to the building management system that the amount of rejected heat at the outlet of the data center is reading at the second temperature.

15. The computer-readable medium of claim 14, wherein, prior to the execution of the thermal reclaiming protocol, the program instructions further cause the processor to:
monitor valve opening positions within a liquid cooling system of the data center; and
responsive to the determination that one or more of the valve opening positions are not currently positioned at a maximum limit, proceed to the execution of the thermal reclaiming protocol; or optionally
wherein, to execute the thermal reclaiming protocol, the program instructions further cause the processor to provide respective messages to control units of the chiller, the indoor cooling unit, and the computing device, wherein the messages indicate that the thermal reclaiming protocol is active; or optionally
wherein, to execute the thermal reclaiming protocol, the program instructions further cause the processor to provide respective messages to control units of the chiller and the indoor cooling unit, wherein the messages indicate that the supply coolant temperature set point has been increased; or optionally
wherein, to execute the thermal reclaiming protocol, the program instructions further cause the processor to provide respective messages to control units of the indoor cooling unit and the computing device, wherein the messages indicate that the other supply coolant temperature set point has been increased.
